**Europäisches Patentamt**

**European Patent Office**

**Office européen des brevets**

(19)

(11) Numéro de publication: **0 198 748 B1**

(12)

# FASCICULE DE BREVET EUROPEEN

(45) Date de publication du fascicule du brevet:
21.03.90

(51) Int. Cl.⁴: **G01N 24/08**

(21) Numéro de dépôt: 86400636.6

(22) Date de dépôt: 25.03.86

(54) Procédé et dispositif d'imagerie par résonance magnétique nucléaire.

(30) Priorité: 26.03.85 FR 8504494

(43) Date de publication de la demande:
22.10.86 Bulletin 86/43

(45) Mention de la délivrance du brevet:
21.03.90 Bulletin 90/12

(84) Etats contractants désignés:
DE GB IT NL

(56) Documents cités:
EP-A-0 117 042
DE-A-3 125 502
GB-A-2 056 088
GB-A-2 113 399

PHYSICS IN MEDICINE AND BIOLOGY,
vol. 25, no. 4, septembre 1980, pages 748-751; C.R. LING
et al.: "Comparison of NMR water proton T1 relaxation
times of rabbit tissues at 24 MHz and 2.5 MHz"
JOURNAL OF NUCLEAR MEDICINE,
vol. 25, no. 3, mars 1984, pages 371-382, New York, US;
J.A. KOUTCHER et al.: "Principles of imaging by nuclear
magnetic resonance"
MEDICAL PHYSICS,
vol. 11, no. 4, juillet/août 1984, pages 425-448, Am.
Assoc. Phys. Med., New York, US; P.A. BOTTOMLEY et

(73) Titulaire: GENERAL ELECTRIC CGR S.A., 100, rue
Camille-Desmoulins, F-92130 Issy les Moulineaux(FR)

(72) Inventeur: Kaplan, Daniel, THOMSON-CSF
SCPI 19, avenue de Messine, F-75008 Paris(FR)
Inventeur: Roux, Georges, THOMSON-CSF
SCPI 19, avenue de Messine, F-75008 Paris(FR)

(74) Mandataire: Ballot, Paul Denis Jacques et al, Cabinet
Ballot-Schmit 7, rue le Sueur, F-75116 Paris(FR)

(56) Documents cités: (suite)
al.: "A review of normal tissue hydrogen NMR relaxation
times and relaxation mechanisms from 1-100 MHz:
dependence on tissue type, NMR frequency,
temperature, species, excision, and
age"RBON), 355-72 000

ACTORUM AG

## Description

La présente invention a pour objet un procédé et un dispositif d'imagerie par résonance magnétique nucléaire du type de ceux mis en oeuvre dans le domaine médical.

L'imagerie par résonance magnétique nucléaire se développe principalement comme moyen de diagnostic médical. Elle permet la visualisation des structures internes tissulaires avec un contraste et une résolution jamais atteints simultanément par les autres procédés d'imagerie. Pour obtenir une image par résonance magnétique nucléaire (IRM) d'une coupe d'organe avec différenciation des caractéristiques tissulaires de cet organe, on utilise la propriété qu'ont certains noyaux atomiques, comme les protons, d'orienter leurs moments magnétiques, associés aux spins du noyau, en acquérant de l'énergie lorsqu'ils sont placés dans un champ magnétique principal $B_0$. Une zone particulière de l'objet contenant des noyaux présente alors un moment magnétique global que l'on peut faire basculer selon une orientation donnée, perpendiculaire ou coaxiale au champ $B_0$, en induisant une résonance par émission d'un champ radiofréquence perpendiculaire au champ principal.

Tous les noyaux possédant alors un moment magnétique tournant à une fréquence de précession, dite de Larmor, tendent à retrouver l'orientation initiale due à $B_0$ en émettant un signal radiofréquence à la fréquence de résonance caractéritique de $B_0$ et du noyau. Ce signal peut être capté par une antenne de réception. La durée de retour à l'équilibre du moment magnétique global d'une région considérée dépend de deux facteurs importants: l'interaction spin-réseau et l'interaction spin-spin des noyaux avec la matière environnante. Ces deux facteurs conduisent à la définition de deux temps de relaxation dit $T_1$ et $T_2$. Une région considérée d'un objet émet donc un signal dont l'intensité dépend de $T_1$, $T_2$, de la densité protonique dans la région, et du temps qui s'est écoulé depuis l'excitation radiofréquence.

Pour localiser une région de l'organe il est nécessaire de repérer la nature de son émission en fonction de conditions locales de champ magnétique. Ces conditions locales sont imposées de façon à ce que la fréquence d'émission soit bien caractéristique de la localisation dans l'espace de la région de l'organe. Pour cela on superpose au champ principal $B_0$ des gradients de champ magnétique pulsés. Ces gradients sont orientés selon des directions X, Y, Z pour définir à tous moments des éléments de volume qui émettent des signaux à des fréquences de précession connues. Pour l'acquisition d'une image les conditions locales sont imposées par des séquences programmées. Celles-ci sont mises en mémoire dans un ordinateur pilote. Ces séquences définissent également les instants d'excitation des noyaux par les impulsions radiofréquences, dites sélectives ainsi que les instants de lecture ou d'acquisition des données de l'image.

Une description de différentes séquences généralement utilisées peut être trouvée dans l'article de W. A. Edelstein et Al, Journal of Computer Assisted Tomography 7 (3) 391.401.1983. Cet article qui passe en revue les performances respectives, eu égard au rapport signal à bruit des données d'image acquises, des différents types de séquences, détermine par ailleurs que de ce point de vue, la plus favorable pour discriminer le temps de relaxation $T_1$ et la séquence dite recouvrement-saturation.

Dans les structures tissulaires les images se différencient par les temps de relaxation $T_1$, $T_2$. Les images présentant un maximum de contraste sont généralement celles qui favorisent la visualisation des différents $T_1$ de ces structures tissulaires. En conséquence les séquences d'acquisition d'un signal IRM sont généralement optimisées pour donner le meilleur rapport signal à bruit au $T_1$ moyen d'un organe ou d'un tissu considéré. Dans ce cas on s'affranchit au mieux des variations de densité protonique et de l'incidence du temps de relaxation $T_2$. Ceci est également indiqué dans l'article précité. Néanmoins certaines erreurs d'évaluation de $T_1$ persistent, et des artefacts dans le contraste de l'image apparaissent. En particulier le contraste en donction de $T_1$ dans toute une tranche d'un corps examiné est perturbé par l'imperfection de l'homogénéité du champ d'excitation radiofréquence et par la forme de l'impulsion sélective. Pour l'inhomogénéité du champ d'excitation ceci est évident: différentes parties de la tranche, excitées de manières différentes, restituent bien entendu ultérieurement des signaux différents. La forme de l'impulsion sélective est également importante du fait que la tranche examinée possède une certaine épaisseur (cette épaisseur est liée à l'énergie du signal reçu). La perturbation dûe à la forme de l'impulsion sélective est liée à la propagation, dans l'épaisseur de la tranche, de l'impulsion d'excitation.

Par ailleurs, il existe des tissus pour lesquels le $T_1$ des parties saines est donné et pour lesquels le $T_1$ de parties lésées est le même. L'image d'une coupe de ce tissu n'est alors pas révélatrice de ces lésions que l'on cherche à montrer.

L'invention consiste alors à obtenir une image dont l'information locale est fonction intrinsèque des paramètres tissulaires présidant à l'émission du signal de résonance. Dans ces conditions l'image n'est plus uniqement fonction des seuls temps de relaxation, en particulier $T_1$; elle est en même temps la plus indépendante possible du séquencement d'acquisition et de l'imperfection d'homogénéité dûe au champ d'excitation et à la forme de l'impulsion sélective.

On connaît par le document DE-A 3 125 502 un procédé d'imagerie par RMN dans lequel on acquiert une image des éléments de volume d'une tranche d'un corps à examiner par discrimination des temps de relaxation longitudinaux $T_1$. Ce procédé y est mis en oeuvre dans un appareil de RMN équipé d'un électroaimant susceptible de fournir une induction magnétique principale $\vec{B}_0$ variable. Ce procédé peut fournir deux images d'une même tranche du corps à étudier en présence d'induction $\vec{B}_0$ différentes pour les deux images. Mais la discrimination entre les deux images n'est fondée que sur la différence des temps de relaxation mesurées. Cette différence ne peut pas être suffisamment significative pour conduire à des images pertinentes. En outre, ce document fait état d'une induction $\vec{B}_0$ continûment variable au cours des séquences de mesure elles-mêmes et sa mise en oeuvre est complexe.

L'invention a pour object un procédé d'imagerie par résonance magnétique nucléaire dans lequel on acquiert une image des éléments de volume d'une tranche d'un corps à examiner par discrimination des temps de relaxation longitudinaux des noyaux de ces éléments de volume en présence d'un champs magnétique orientateur $\vec{B}_0$ donné et l'on réitère cette acquisition pour une autre valeur du champ $\vec{B}_0$ caractérisé en ce que l'on compose une nouvelle image de la tranche par représentation pour chaque élément d'image des variations relatives desdits temps de relaxation entre cette première et cette deuxième acquisition.

L'invention a également pour objet un dispositif d'imagerie par résonance magnétique nucléaire du type comportant:

- des moyens pour soumettre un corps à examiner à un champ magnétique orientateur $B_0$;
- des moyens de gradient de champ pour déterminer une tranche du corps,
- des moyens de production d'un champ magnétique alternatif impulsionnel pour exciter les noyaux des éléments de volume de la tranche,
- des moyens de mesure des temps de relaxation de ces noyaux après excitation,
- et des moyens d'acquisition d'une image de la tranche par représentation de ces temps de relaxation,
- caractérisé en ce qu'il comporte :
- des moyens pour garder l'image acquise en mémoire,
- des moyens pour faire varier le champ $B_0$ et la fréquence du champ magnétique alternatif impulsionnel de sorte à acquérir, selon la même processus, une autre image de la même tranche,
- et des moyens de composer une image de la tranche, d'un autre type, par représentation des variations relatives des temps de relaxation entre la première et la deuxième acquisition.

L'invention sera mieux comprise à la lecture de la description qui suit et à l'examen des figures qui l'accompagent. Celles-ci sont données à titre indicatif et nullement limitatif de l'invention. Elles représentent :

- figure 1, un dispositif conforme à l'invention;
- figures 2a et 2b, une représentation schématique d'images obtenues sans et avec le procédé de l'invention;
- figure 3, une courbe relevée dans une variante de mise en oeuvre du procédé.

La théorie de la résonance magnétique d'une part, confirmée par de nombreuses expériences d'autre part, a montré que $T_1$ et $T_2$ dépendent de la fréquence de précession, ou de résonance. Celle-ci est par ailleurs directement proportionnelle au champ principal $B_0$ dans lequel sont plongés les noyaux. Il est possible d'exprimer la dépendance de $T_1$ avec $B_0$ selon une relation telle que :

$$T_1 = f(\alpha, m, B_0)$$

où $\alpha$ et $m$ sont des paramètres dépendant des structures des tissus. Ces paramètres définissent le degré d'attachement et de mobilité des noyaux (protons) des tissus. Ces paramètres sont représentatifs des héterogénéités de champ au niveau microscopique et molléculaire. Par exemple une fonction, bien corrélée avec diverses expériences, est de la forme :

$$T_1 = m.B_0^\alpha.$$

Selon l'invention on en déduit que pour une variation $\Delta B_0$ de $B_0$ on obtient une variation $\Delta T_1$ de $T_1$ de la forme :

$$\Delta T_1 = f'(B_0) \Delta B_0 \text{ si } \Delta B_0 \text{ est petit devant } B_0.$$

Dans l'exemple donné cette formulation devient :

$$\Delta T_1 = m \alpha B_0^{\alpha-1}. \Delta B_0.$$

L'idée de l'invention est alors d'acquérir et de traiter des images à des champs $B_0$ différents, de façon à ce que seules les différences de $T_1$ soit prépondérantes dans l'image finale. Dans ce cas on obtient une image dont le contraste principal est fonction des paramètres de structure tissulaire $m$ et $\alpha$.

Considérons un élément d'image, ou pixel $\underline{i}$, qui représente un élément de volume dont le temps de relaxation est $T_{1,i}$. L'amplitude du signal $I$ reçu concernant ce pixel $\underline{i}$ est de la forme

$$I_i = h(\rho_i) \times k(T_{1,i}) \times g(T_{2,i}).$$

Dans cette expression $\rho_i$ est la densité de protons ou de noyaux dans la région $i$, et $T_{1,i}$ et $T_{2,i}$ sont les valeurs des temps de relaxation $T_1$ et $T_2$, à $B_0$, dans la même région. Les fonctions $h$, $k$, et $g$ sont de type proportionnel à respectivement $\rho_i$, $T_{1,i}$ et $T_{2,i}$. Par la variation $\Delta B_0$ du champ magnétique principal on obtient un nouveau signal $I$ différent du précédent. La variation du signal $I$ s'exprime sous la forme d'une différentielle totale exacte :

$$\Delta I_i = h(\rho_i) \times k'(T_{1,i}). \Delta T_{1,i} \times g(T_{2,i}).$$

La part relative à la dérivée de la fonction $\underline{g}$ par rapport à la variation du champ $B_0$ est négligée. Ceci ce justifie parce que dans l'expérience on choisit des séquences d'excitation-mesure aptes à mesurer $T_1$ plutôt que $T_2$. En conséquence les mesures de $I$ sont par nature assez indépendantes de $T_2$. Mais par ailleurs, l'indépendance parfaite de la mesure de $T_1$ à l'égard de $T_2$ étant impossible, une deuxième raison de l'élimination de la dérivée de $\underline{g}$ par rapport à $B_0$ repose sur le fait que la valeur de $T_2$ est peu affectée par la variation du champ orientateur : c'est connu expérimentalement. On considère alors dans l'invention le rapport $\Delta I_i/I_i$ qui est égal à :

$$\Delta I_i/I_i = k'(T_{1,i}). \Delta T_{1,i}/ k(T_{1,i}).$$

On se rend compte alors qu'une image nouvelle dont la luminosité des pixels serait proportionnelle à la variation relative de l'intensité $I_i$ en chaque point, variation due à la variation du champ principal, est essentiellement dépendante des variations relatives des $T_1$ et non pas des $T_1$ eux-mêmes. La conséquence de cette situation est que les structures tissulaires peuvent être différenciées dans l'image nouvelle même si par ailleurs elles possèdent un même temps de relaxation $T_1$. En effet, en remplaçant $\Delta$ $T_1$ par sa valeur calculée par le fonction f, en particulier celle indiquée dans l'exemple ci-dessus, on peut écrire :

$$\Delta l_i/l_i = A(m_i, \alpha_i) \cdot m_i \cdot \alpha_i \cdot B_0^{\alpha_i - 1} \cdot \Delta B_0$$

où A représente la fonction k'/k. Cette expression est à rapprocher de l'expression de $l_i$ qui en définitive était représentative de $T_1$. Dans l'exemple bien corrélé $l_i$ était proportionnel à $m_i \cdot B_0^{\alpha_i}$. Entre l'expression de $l_i$ et celle de $\Delta l_i/l_i$ l'exposant $\alpha_i$ apparaît maintenant en terme multiplicateur direct. La combinaison des paramètres m et $\alpha$ qui est représentée est donc bien différente de l'arrangement de ces paramètres qui était représentatif de $T_1$. Ceci signifie que deux éléments de volume adjacents, i et j, qui donneraient lieu à des mêmes temps de relaxation $T_1$ peuvent être discriminés dans l'image nouvelle en des dessins séparés si par ailleurs leurs couples de paramètres $m_i$, $\alpha_i$ et $m_j$, $\alpha_j$ sont différents.

Le nouveau type d'image ainsi élaborée s'affranchit par ailleurs des perturbations amenées par les impulsions radiofréquences sélectives. On a vu que les perturbations imposées aux temps de relaxation sont apportées par les inhomogénéités des champs d'excitation. Il en résulte que la structure générale des machines est adaptée pour résoudre "au mieux" ces problèmes. Dans l'invention, et à condition que les perturbations appliquées soient les mêmes d'une expérimentation à l'autre quand $B_0$ évolue, le fait d'effectuer une mesure relative normalise les mesures. On élimine ainsi en chaque points les inhomogénéités mesurées puisque les mesures en chaque point ne sont plus alors comparées, comme c'est le cas pour une image classique, les unes par rapport aux autres, d'un point adjacent à un autre point adjacent, mais plutôt en un même point, d'une mesure à un $B_0$ donné à une mesure à un autre $B_0$ donné. Il en résulte l'avantage attendu que la forme de l'impulsion de sélection et que l'homogénéité du champ d'excitation deviennent moins critiques.

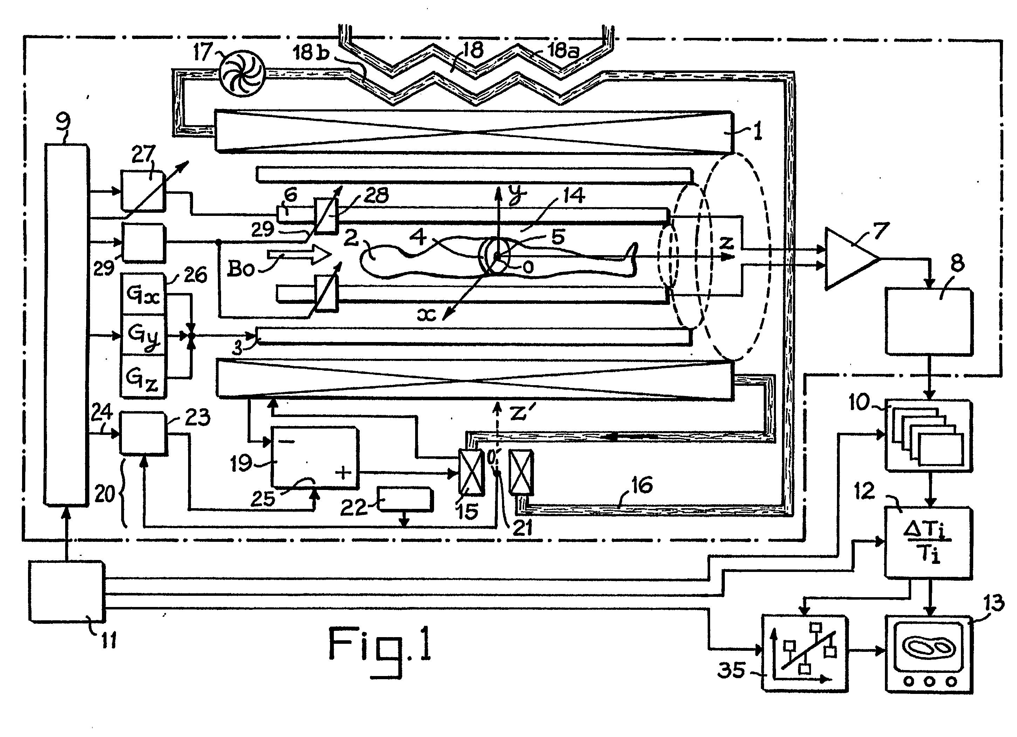

La figure 1 montre un dispositif apte à mettre en oeuvre le procédé d'imagerie de l'invention. Ce dispositif comporte des moyens 1 pour soumettre un corps à examiner 2 à un champ magnétique orientateur $B_0$. Il comporte encore classiquement des moyens 3 pour produire des gradients de champs selon trois axes x, y et z de manière à déterminer dans le corps une tranche 4 qui comporte les éléments de volume 5 dont on veut donner une image. Ce dispositif comporte encore des moyens 6 de production d'un champ magnétique alternatif impulsionnel pour exciter les noyaux des éléments de volume. Des moyens de mesure 7, qui élaborent des mesures relatives à la valeur des temps de relaxation des noyaux des éléments, sont reliés à des moyens 8 d'acquisition d'une image de la tranche. Toute cette chaine de mesure comporte des moyens connus en eux-mêmes ainsi que dans leur association. En particulier, tous ces moyens fonctionnent sous le pilotage d'un séquenceur 9 d'acquisition programmée.

Une des particularités du dispositif de l'invention est qu'il possède des moyens 10 pour garder l'image acquise en mémoire, et des moyens 11 pour faire varier les conditions de mesure. Dans l'invention ces conditions de mesure concernent le champ $B_0$ ainsi que la fréquence du champ magnétique alternatif impulsionnel d'excitation. Une fois que les conditions de mesure ont été modifiées on acquiert une autre image. Une autre particularité de l'invention est que le dispositif comporte alors en plus des moyens 12 de composition d'une image, d'un autre type, de la tranche en question par représentation des variations relatives des temps de relaxation entre la première et la deuxième acquisition. Ces variations relatives des temps de relaxation sont estimées en fait sous la forme des variations relatives des amplitudes des signaux mesurés. La justification en a été donnée plus haut. Accéssoirement des moyens de visualisation 13 permettent d'afficher l'image d'un autre type ainsi élaborée.

Le changement des conditions de mesure est fait dans l'invention d'une manière préferée en utilisant un dispositif décrit dans une précédente demande de brevet français de la demanderesse déposée sous le n° 84.19190. Dans celui-ci un système d'aimants résistifs peut être régulé pour délivrer un champ magnétique orientateur attendu. Ce système se compose essentiellement de l'aimant résistif 1 de grande dimension. Celui-ci est conçu pour créer un champ magnétique relativement intense et très homogène dans une région 14 de son volume interne. Ce système comporte encore un aimant auxiliaire 15 de petite dimension et un circuit de circulation d'un fluide de refroidissement 16 en contact thermique avec les aimants 1 et 15. Dans une application d'imagerie, l'aimant 1 est conçu pour engendrer un champ magnétique compris en O,15 et O,5 tesla dans une sphère de 50 cm de diamètre de centre O ( le centre de symétrie de l'aimant) et avec une homogénéité de 1 à 10 ppm (parties par million).

De préférence l'élément principal 1 comporte au moins une bobine de Bitter. On entend par "bobine de Bitter" une bobine constituée de disques annulaires métalliques (typiquement en cuivre ou en aluminium) définissant des spires d'un solénoïde. Ces disques sont électriquement isolés les uns des autres (le plus souvent avec interposition de feuilles isolantes de forme semblable) mais connectés bout à bout pour matérialiser ledit solénoïde. Des trous pratiqués dans les disques et les isolants définissent des canaux qui s'étendent sensiblement parallèlement à l'axe longitudinal du solénoïde et dans lesquels circule le fluide de refroidissement.

Dans tous les cas l'aimant 1 a une structure permettant un échange thermique efficace entre les enroulements de la ou les bobines résistives le constituant et le fluide de refroidissement. Il en est de même de l'aimant 15 qui est agencé pour recevoir le même fluide de refroidissement de façon à être toujours sensiblement à la même température que l'aimant principal. Il est a noter à ce propos que la résistance interne de l'aimant auxiliaire est très faible par rapport à celle de l'aimant principal de sorte que sa contribution à l'échauffement du fluide circulant dans le circuit 16 soit pratiquement négligeable. En outre les bobines des deux aimants 1 et 15 sont réalisées dans le même matériau conducteur notamment le cuivre ou l'aluminium.

Le circuit 16 comporte en outre une pompe de circulation 17 et un échangeur 18 dont le circuit secondaire 18b est traversé par le fluide de refroidissement, et dont le circuit primaire 18a est alimenté par de l'eau froide en circulation. Dans l'exemple représenté le circuit 16 est conçu pour que la totalité du fluide de refroidissement traverse l'aimant auxiliaire 15, mais il est envisageable, par une dérivation appropriée, de ne faire circuler qu'une partie de ce fluide dans l'aimant 15 pour autant que la température de ce dernier soit toujours sensiblement égale à celle de l'aimant 1, à tous moments. Dans cet esprit, il est particulièrement important que le circuit 16 soit agencé de telle sorte que le fluide entrant dans l'aimant 15 provienne directement de l'aimant principal 1 sans passer par l'échangeur 18.

Par ailleurs, les bobines des aimants 1 et 15 sont, à tous moments, traversées par un même courant délivré par une source de courant continu 19. L'aimant 15 a pour fonction de créer un champ magnétique témoin représentatif du champ de l'aimant principal dans au moins un volume de son espace interne où sont placés des moyens de mesure dudit champ témoin, pour piloter une chaine d'asservissement 20 du courant délivré par la source de courant continu 19. Selon un mode de réalisation préféré, ces moyens de mesure du champ témoin comportent une sonde de RMN 21 pour piloter la chaine d'asservissement 20, ladite sonde étant placée dans ledit volume restreint. Pour obtenir un signal RMN exploitable, l'aimant auxiliaire 15 est construit pour que le champ témoin soit d'homogénéité suffisante dans le volume restreint où se trouve placée la sonde. En pratique, l'homogénéité du champ témoin dans le volume environnant la sonde doit être de 1 à 10 ppm, c'est-à-dire du même ordre de grandeur que l'homogénéité du champ de base dans le volume utile dans l'aimant principal.

Les aimants 1 et 15 admettent chacun un axe longitudinal de symétrie, respectivement Oz et O'z', O et O' étant les centres de symétrie de ces aimants. Selon un exemple possible de réalisation non revendiquée, l'axe O'z' de l'aimant auxiliaire 15 est sensiblement placé dans un plan transversal médian (contenant le point O) de l'aimant principal 1 de façon à couper l'axe O z au point O. L'aimant 15 reste bien entendu extérieur à l'aimant 1. Cette agencement est celui qui offre le couplage parasite le plus faible possible entre les deux aimants et qui perturbe donc le moins l'homogénéité des deux champs. Avec le système décrit ci-dessus, le courant délivré par la source de courant continu 19 est ajusté en permanence pour réguler la valeur du champ dans l'aimant 15. Ce champ dépend de la température de l'aimant. En s'arrangeant comme on l'a vu plus haut pour que la température de l'aimant 15 soit la même que celle de l'aimant principal on obtient le résultat suivant que les champs dans les deux aimants sont toujours proportionnels l'un à l'autre. En conséquence, la régulation du champ dans l'aimant auxiliaire entraîne la régulation du champ dans l'aimant principal.

La chaine d'asservissement 20 est classique et ses constituants sont disponibles dans le commerce, notamment pour les applications de spectrométrie. La sonde RMN 21 comporte en particulier une bobine de couplage entourant un échantillon d'atomes choisis. La chaine d'asservissement comporte essentiellement un générateur radiofréquence 22 alimentant la bobine de couplage de la sonde et émettant un signal à fréquence variable dans le temps. Un balayage d'une certaine plage de fréquence incluant la fréquence de RMN est donc appliqué à la sonde. Par ailleurs la chaine d'asservissement 20 comporte aussi des moyens de mesure 23 du signal radiofréquence aux bornes de ladite bobine de couplage. Lorsque le générateur 22 est à la fréquence de RMN de l'échantillon, un phénomène d'absorption d'énergie se produit, et le signal radiofréquence, aux bornes de la bobine, est très fortement atténué. Le signal d'absorption est comparé à une référence 24 pour élaborer un signal d'erreur qui est appliqué à une entrée de pilotage 25 de la source d'alimentation 19. Le balayage à fréquence variable est répété régulièrement de façon à constamment réactualiser la valeur du signal d'erreur appliqué à l'entrée de pilotage 25.

Le dispositif utilisé dans l'invention est pourvu d'un système de bobinage de correction (appelé "shims") connu en soi et non représenté, essentiellement destiné à compenser les effets perturbateurs de l'environnement de l'aimant. L'aimant 1 chargé d'élaborer le champ orientateur est associé à un système de bobines de gradient 3 connu en soi. Les bobines de gradient sont agencées sur un mandrin tubulaire cylindrique placé à l'intérieur de l'espace interne 14 de l'aimant 1 coaxialement à l'axe Oz. Le système de bobines de gradient est complété par un ensemble 26 d'alimentation en courant continu (Gx, Gy, Gz) commandé suivant un cycle de séquences pré-programmées dans le séquenceur 9. De cette façon des gradients de champ magnétique, d'intensité et d'orientation différentes prédéterminées, sont superposés au champ orientateur au cours desdites séquences. On sait que ces gradients permettent, entre autre, de sélectionner une tranche 4 dont on désire construire l'image. Un système 6 d'antennes radiofréquences est également logé à l'intérieur de l'espace utile 14 de l'aimant 1. Ces antennes font partie de moyens d'émission-réception radiofréquence qui comportent un générateur radiofréquence 27 piloté par le séquenceur 9. Ce générateur 27 produit des impulsions calibrées de signal radiofréquence pendant les séquences. Les signaux RMN réémis par le corps en cours d'examen sont captés par le même système d'antennes. Ils sont exploités après leur réception dans le récepteur 7 relié à ces antennes.

Dans l'invention le fonctionnement du séquenceur 9 est modifié quand les conditions de mesures doivent être changées. En particulier une nouvelle grandeur de consigne est appliquée en 24 pendant la deuxième acquisition d'image pour modifier la valeur du champ orientateur $B_0$ par action sur la chaine de régulation 20. Avec le dispositif décrit cette modification est rapidement stabilisée : une nouvelle valeur de champ $B_0$ est établie en un temps de l'ordre, ou inférieur, à la minute. Pour tenir compte de la variation du champ orientateur l'antenne 6 est alors accordée sur une nouvelle fréquence de résonance au moyen de capacités variables 28 mises en parallèle avec les brins d'antennes. Ces capacité sont actionnées par des manettes motorisée 29 totalement amagnétiques. Une antenne de ce type est décrite dans la demande de brevet européen n° 82.107332.7.Le générateur 27 est également accordé pour que la fréquence des impulsions radiofréquences corresponde aux nouvelles conditions de mesure.

Les moyens 12 de traitement d'images comportent essentiellement des moyens pour calculer, pixel par pixel, les variations d'intensité des signaux reçus entre les deux expériences, et des moyens pour normaliser ces variations par rapport à une ou l'autre de ces deux intensités. Ces moyens 12, qui effectuent pour chaque pixel une soustraction suivie d'une division, sont, d'une manière préférée, inclus dans un ordinateur programmé. Cet ordinateur est, si possible, le même que celui qui effectue l'acquisition de l'image classique. Dans ce cas le programme général de traitement des données de mesure comporte une partie affectée à l'exécution des tâches décrites dans l'invention.

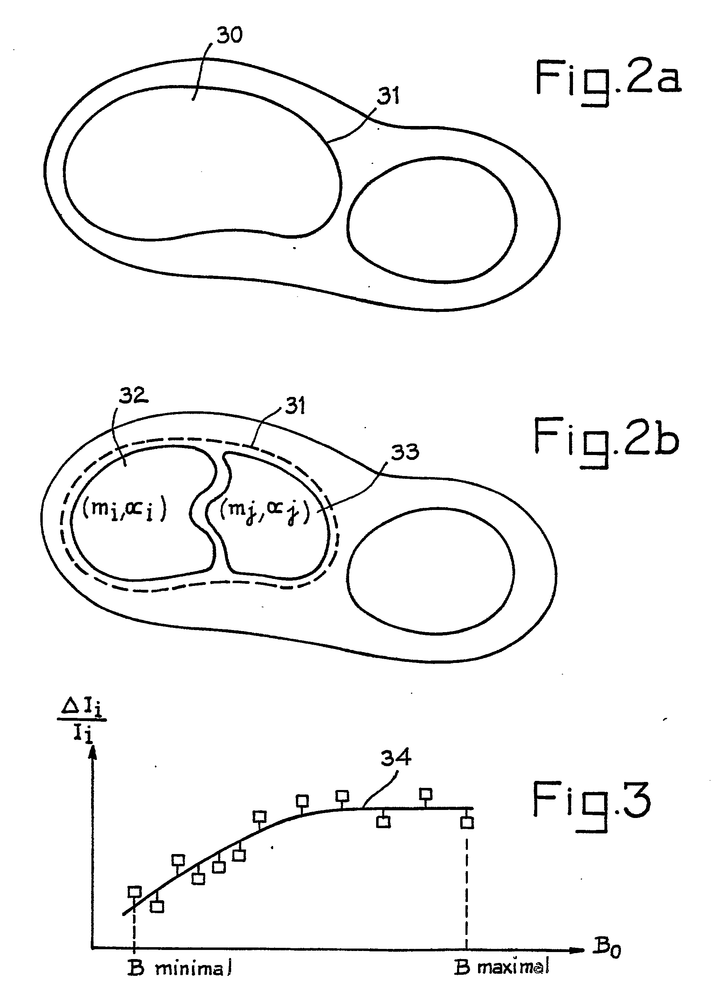

Les figures 2a et 2b représentent schématiquement la topologie des images que l'on peut acquérir selon un procédé connu de l'état de la technique (a) et selon le procédé de l'invention (b).Dans l'image de la tranche représentée, un tissu 30 est délimité par son contour 31. La caractéristique de ce tissu qui a présidé à l'établissement de cette image est l'uniformité, pour toutes les régions de ce tissu, du temps de relaxation ($T_1$). Sur la figure 2b, si le contour 31 peut encore être deviné, c'est essentiellement parce qu'il circonscrit deux régions 32 et 33 bien dessinées et dont les paramètres tissulaires sont différents d'une région à l'autre : les indices $i$ d'une part et $j$ d'autre part. Ces régions sont biens différenciées car elle correspondent à des $\Delta$ I/I différents. Finalement l'image globale reste la même mais une dimension suplémentaire de différenciation est apparue. Dans certains cas elle peut permettre de discriminer des parties lésées d'un tissu.

Dans une variante, plutôt que de n'effectuer que deux expérimentations pour deux $B_0$ légèrement différents, il est prévu de faire varier $B_0$ entre une valeur minimale et une valeur maximale. Pour chaque variation de $B_0$ on peut calculer les variations relatives des intensités des signaux reçus, et ce pixel par pixel. Pour chacun de ces pixels on peut donc rassembler une série de variations relatives de temps de relaxation en fonction de la valeur de $B_0$ autour de laquelle elles ont été mesurées. La théorie de la résonance montre par ailleurs que ces variations doivent se trouver au voisinage d'une courbe expérimentale 34 (figure 3) représentative du tissu du pixel étudié. Pour chaque pixel, on détermine alors la courbe 34 par estimation statistique. D'une manière préférée cette courbe 34 correspond à une estimation statistique dans laquelle l'écart quadratique entre la courbe et les variations relatives est minimale. Cette estimation statistique de la courbe 34 est dite méthode des moindres carrés. Cette courbe étant calculée,la variante de l'invention permet de s'affranchir des bruits de mesure en remplaçant, pour chaque pixel et à chaque valeur de $B_0$, la variation relative calculée par la valeur estimée correspondante. Cette méthode àméliore le rapport signal à bruit dans l'image des variations relatives. Pour arriver à ce résultat, en cascade avec les moyens 12 de calcul de l'image d'un autre type, on peut disposer des moyens 35 de mémorisation et de traitement statistique de ces images. La mémorisation requiert une capacité de mémoire suffisante, le traitement statistique peut être de tout type connu. Les moyens 35 peuvent également être inclus dans l'ordinateur de l'acquisition d'image classique. L'ordinateur 11 qui pilote la mise en oeuvre de ce procédé nouveau est préprogrammé pour accomplir successivement toutes les acquisitions, toutes les compositions d'images et éventuellement, tous les traitements statistiques nécessaires.

Pour la mise en oeuvre du procédé ci-dessus décrit il est nécessaire que le corps, dans le domaine médical celui d'un patient, reste immobile pendant les différentes acquisitions. Ceci impose que ces acquisitions soient effectuées à des intervalles de temps ne dépassant pas quelques minutes. Ceci est particulièrement possible avec la solution, notamment avec aimant de Bitter, ci-dessus décrite.

## Revendications

1. Procédé d'imagerie par résonance magnétique nucléaire dans lequel on acquiert une image des éléments (5) de volume d'une tranche (4) d'un corps (3) à examiner par discrimination des temps ($T_1$) de relaxation longitudinaux des noyaux de ces éléments de volume en présence d'un champ magnétique orientateur $\vec{B}_0$ donné et l'on réitère cette acquisition pour une autre valeur du champ $\vec{B}_0$ caractérisé en ce que l'on compose une nouvelle image de la tranche (4) par représentation pour chaque élément d'image des variations relatives desdits temps de relaxation entre cette première et cette deuxième acquisition.

2. Procédé selon la revendication 1, caractérisé en ce que l'on réitère les acquisitions un certain nombre de fois, à chaque fois pour des valeurs différentes du champ et en ce qu'on compose l'image de la tranche (4) par représentation des variations relatives des temps de relaxation en effectuant une estimation statistique des variations relatives.

3. Procédé selon la revendication 2, caractérisé en ce que l'estimation statistique est établie en écart quadratique minimal.

4. Dispositif d'imagerie par résonance magnétique nucléaire du type comportant
   - des moyens (1, 15-25) pour soumettre un corps (2) à examiner à un champ magnétique orientateur $\vec{B}_0$,
   - des moyens (3, 26) de gradient de champ pour déterminer une tranche (4) du corps (2),
   - des moyens (6, 27) de production d'un champ magnétique alternatif impulsionnel pour exciter les noyaux des éléments (5) de volume de la tranche (4),

- des moyens (7) de mesure des temps (T₁) de relaxion longitudinaux de ces noyaux après excitation,
- des moyens (8) pour effectuer une première acquisition d'une image de la tranche (4) par représentation de ces temps de relaxation,
- des moyens (10) pour garder l'image acquise en mémoire,
- des moyens (11, 24, 28, 29) pour faire varier le champ $\vec{B}_0$ et la fréquence du champ magnétique impulsionnel afin d'effectuer selon le même processus une deuxième acquisition sous la forme d'une autre image de la même tranche (4) caractérisé en ce qu'il comporte, en outre,
- des moyens (12) pour composer une image de la tranche (4) d'un autre type par représentation, des variations relatives desdits temps de relaxation (T₁) entre la première et la deuxième acquisition.

5. Dispositif selon la revendication 4, caractérisé en ce qu'il comporte des moyens (11) pour réitérer les acquisitions un certain nombre de fois à chaque fois pour des valeurs différentes du champ, et en ce qu'il comporte en outre des moyens (35) pour effectuer une estimation statistique des variations relatives desdits temps de relaxation à représenter.

6. Dispositif selon la revendication 4 ou la revendication 5, caractérisé en ce que les moyens pour soumettre le corps (3) au champ magnétique orientateur B₀ comporte des bobines dites de Bitter traversées par un courant électrique asservi.

## Claims

1. A method for the production of an image using nuclear magnetic resonance in which an image of elements (5) is acquired from the volume of a slice (4) of a body (3) to be examined by discrimination of the longitudinal relaxation times (T₁) of the nuclei of these volume elements in the presence of a given orientating magnetic field $\vec{B}_0$, and this acquisition is reiterated for another value of $\vec{B}_0$ characterized in that the a new image of the slice (4) is composed by the representation for each element of the image of the relative variations of the said relaxation times between this first acquisition and this second one.

2. The method as claimed in claim 1 characterized in that the acquisition is reiterated a certain number of times, each time being for different values of the field and in that the image of the slice (4) is composed by representation of the relative variations in the relaxation times and by performing a statistical estimation of the relative variations.

3. The method as claimed in claim 2 characterized in that the statistical estimation is established with a minimum square shift.

4. A device for the production of an image by nuclear magnetic resonance of the type comprising:
– means (1, and 15 through 25) in order to submit a body (2) to be examined to an orientating magnetic field $\vec{B}_0$,

– field gradient means (3 and 26) in order to determine a slice (4) of the body (2),
– means (6 and 27) for the production of an alternating pulsed magnetic field in order to excite the nuclei of the elements (5) in the volume of the slice (4),
– means (7) for measuring the times (T₁) of longitudinal relaxation of these nuclei after such excitation,
– means (8) for performing a first acquisition of an image of the slice (4) by representation of these relaxation times,
– means (10) in order to store the acquired image in a memory,
– and means (11, 24, 28 and 29) in order to cause variation in the field $\vec{B}_0$ and in the pulsed magnetic field in order to perform, using the same routine, a second acquisition in the form of another image of the same slice (4), characterized in that it furthermore comprises:
– means (12) to compose an image of the slice (4) of another type by representation of the relative variations of the said relaxation times (T₁) between the first and the second acquisition.

5. The device as claimed in claim 4 characterized in that it comprises means (11) in order to reiterate the acquisitions a certain number of times at each time for different values of the field and in that it furthermore comprises means (35) in order to perform a statistical estimation of the relative variations of the said relaxation times to be represented.

6. The device as claimed in claim 4 or in claim 5 characterized in that the means for submitting the body (3) to the orientating magnetic field B₀ comprise Bitter coils having a controlled electric current flowing through them.

## Patentansprüche

1. Verfahren zur Bilderzeugung mittels magnetischer Kernresonanz, bei dem ein Bild der Volumenelemente (5) eines Schnitteils (4) eines zu untersuchenden Körpers (3) durch Ausscheidung der Längs-Relaxationszeiten (T₁) der Atomkerne dieser Volumenelemente bei Vorhandensein eines gegebenen magnetischen Richtfeldes $\vec{B}_0$ erfaßt wird und diese Erfassung für einen anderen Wert des Feldes $\vec{B}_0$ wiederholt wird, dadurch gekennzeichnet, daß ein neues Bild des Schnitteils (4) durch für jedes Bildelement erfolgende Darstellung der Relativschwankungen dieser Relaxationszeiten zwischen dieser ersten und dieser zweiten Erfassung zusammengesetzt wird.

2. Verfahren nach Anspruch 1, dadurch gekennzeichnet, daß die Erfassungen eine bestimmte Anzahl von Malen wiederholt werden, jedes Mal für unterschiedliche Feldwerte, und daß das Bild des Schnitteils (4) durch Darstellung der Relativschwankungen der Relaxationszeiten zusammengesetzt wird, bei Durchführung einer statistischen Schätzung der Relativschwankungen.

3. Verfahren nach Anspruch 2, dadurch gekennzeichnet, daß die statistische Schätzung für minimale quadratische Abweichung aufgestellt wird.

4. Vorrichtung zur Bilderzeugung mittels magnetischer Kernresonanz des Typs mit

- Mitteln (1, 15-25), um einen zu untersuchenden Körper (2) einem magnetischen Richtfeld $\vec{B}_0$ auszusetzen,

- Feldgradientmittel (3, 26) um einen Schnitteil (4) des Körpers (2) zu bestimmen,

- Mittel (6, 27) zur Herstellung eines impulsionellen magnetischen Wechselfeldes, um die Atomkerne der Volumenelemente (5) des Schnitteils (4) zu erregen,

- Mittel (7) zur Messung der Längs-Relaxationszeiten ($T_1$) dieser Atomkerne nach Erregung,

- Mittel (8) zur Durchführung eines Bildes des Schnitteils (4) durch Darstellung dieser Relaxationszeiten,

- Mittel (10) zur Bewahrung des erstellten Bildes im Speicher,

- Mittel (11, 24, 28, 29), um das Feld $\vec{B}_0$ und die Frequenz des impulsionellen Magnetfeldes schwanken zu lassen, damit gemäß demselben Verfahren eine zweite Erfassung in Form eines anderen Bildes desselben Schnitteils (4) durchgeführt wird, dadurch gekennzeichnet, daß es außerdem umfaßt

- Mittel (12) zur Zusammensetzung eines Bildes des Schnitteils (4) eines anderen Typs durch Darstellung der Relativschwankungen dieser Relaxationszeiten ($T_1$) zwischen der ersten und der zweiten Erfassung.

5. Vorrichtung nach Anspruch 4, dadurch gekennzeichnet, daß sie Mittel (11) umfaßt, um die Erfassungen eine gewisse Anzahl von Malen jedesmal für unterschiedliche Feldwerte zu wiederholen, und daß es außerdem Mittel (35) zur Durchführung einer statistischen Schätzung der Relativschwankungen dieser darzustellenden Relaxationszeiten umfaßt.

6. Vorrichtung nach Anspruch 4 oder Anspruch 5, dadurch gekennzeichnet, daß die Mittel, um den Körper (3) dem magnetischen Richtfeld $\vec{B}_0$ auszusetzen, sogenannte Bitter-Spulen umfassen, die von einem nachgeregelten elektrischen Strom durchflossen sind.

Fig.1

EP 0 198 748 B1

Fig.2a

Fig.2b

Fig.3